Europäisches Patentamt

European Patent Office

Office européen des brevets

(19)

(11) Veröffentlichungsnummer : **0 269 812 B1**

# (12) EUROPÄISCHE PATENTSCHRIFT

(45) Veröffentlichungstag der Patentschrift :
06.02.91 Patentblatt 91/06

(51) Int. Cl.⁵ : **G06F 1/04**, H03K 5/19,
H04L 7/02

(21) Anmeldenummer : 87114520.7

(22) Anmeldetag : 05.10.87

(54) Verfahren und Anordnung zur Versorgung einer Taktleitung mit einem von zwei Taktsignalen in Abhängigkeit vom Pegel eines der beiden Taktsignale.

(30) Priorität : 16.10.86 DE 3635294

(43) Veröffentlichungstag der Anmeldung :
08.06.88 Patentblatt 88/23

(45) Bekanntmachung des Hinweises auf die
Patenterteilung :
06.02.91 Patentblatt 91/06

(84) Benannte Vertragsstaaten :
AT BE CH DE FR GB IT LI NL SE

(56) Entgegenhaltungen :
US-A- 3 795 872

(73) Patentinhaber : Siemens Aktiengesellschaft
Wittelsbacherplatz 2
D-8000 München 2 (DE)

(72) Erfinder : Clasen, Peter-Michael, Dipl.-Ing.
Riedenerstrasse 12 a
D-8000 München 71 (DE)

## Beschreibung

Die Erfindung betrifft ein Verfahren zur Versorgung einer Leitung mit Taktsignalen, die entweder aus Pegelschwankungen aufweisenden und über eine erste Leitung übertragenen Taktsignalen oder aus annähernd digitalen und über eine zweite Leitung übertragenen Taktimpulsen in Abhängigkeit vom Pegel der auf der ersten Leitung übertragenen Taktsignale gebildet sind.

In der Nachrichtentechnik sind Verfahren bekannt, mit denen aus einem seriell an einer Einrichtung ankommenden Bitstrom ein Takt regeneriert wird, der in diesen nachrichtentechnischen Einrichtungen als Verarbeitungsbittakt eingesetzt wird. Um bei Ausfall des an der Einrichtung ankommenden Bitstroms die Versorgung der Einrichtung mit einem Bittakt zu gewährleisten, wird mittels hierfür geeigneter Umsteuerverfahren auf einen in der Einrichtung erzeugten internen Verarbeitungsbittakt umgeschaltet. Ein derartiges Umsteuerverfahren ist aus der US-Patentschrift 3,795,872 bekannt. Hierbei wird ein Hauptoszillator durch einen ankommenden Bitstrom nach dem Phase- Locked- Loop- Verfahren synchronisiert. Bei Ausfall des ankommenden Bitstromes wird auf interne im Hauptoszillator gebildete Bittaktsignale umgeschaltet. Fällt dagegen der Hauptoszillator aus, so wird der ankommende Bitstrom auf einen Ersatzoszillator gesteuert mit dessen Hilfe die erzeugten Taktsignale ebenfalls nach dem Phase- Locked- Loop- Verfahren auf den ankommenden Bitstrom synchronisiert werden. Pegelschwankungen treten bei diesem Phase- Locked-Loop- Verfahren nicht auf. Bei sehr hohen Datenbitstromgeschwindigkeiten - z. B. bei ringförmigen lokalen oder öffentlichen Netzen - werden unter anderem auf der Oberflächenwellenfiltertechnik basierende Taktrückgewinnungsverfahren eingesetzt. Ein solcher, mit Oberflächenwellenfilter ausgestatteter Taktregenerator - für Datenstromgeschwindigkeiten von 50 bis 200 MBit - ist aus der Druckschrift LWL-Komponenten Wandler-, Sender- und Empfänger-Meßzubehör, Seite 92 bis 95 von Siemens bekannt. Hierbei werden die ankommenden Datensignale zunächst differenziert und gleichgerichtet und einem Oberflächenwellenfilter zugeführt. Anschließend wird das Filterausgangssignal wieder verstärkt und steht an einem Ausgang als regenerierter Takt zur Verfügung. Weist der ankommende Datenbitstrom jedoch Phasensprünge - in ringförmigen Netzen beispielsweise bei Zu- und Abschalten von Stationen häufig vorkommend - auf, so führt dies zu einer wesentlichen Absenkung des Pegels der am Ausgang vorliegenden Taktsignale und bei Unterschreiten von jeweils für bestimmte Schaltkreistechniken vorgegebenen Mindestspannungspegeln zu erheblichen Störungen bzw. zu undefinierten Zuständen in den durch diesen Takt getakteten Systemkomponenten, beispielsweise einer Zugriffssteuerung eines ringförmigen Netzes.

Der Erfindung liegt die Aufgabe zugrunde, diese Pegelschwankungen der Taktausgangssignale durch Umschalten bzw. Zurückschalten auf einen in der nachrichtentechnischen Einrichtung erzeugten Verarbeitungtakt zu überbrücken und Störungen des Verarbeitungtaktsignals während der Umsteuervorgänge zu vermeiden.

Diese Aufgabe wird ausgehend von den eingangs beschriebenen Verfahren durch die kennzeichnenden Merkmale des Anspruchs 1 gelöst.

Der mit der Erfindung erzielbare Vorteil besteht insbesondere darin, daß wegen der Überprüfung jedes einzelnen Taktsignals hinsichtlich der Pegelhöhe ein Unterschreiten bzw. Überschreiten der Pegelschwellen sehr schnell festgestellt und anschließend auf die jeweils anderen Taktsignale umgeschaltet werden kann. Des weiteren kann durch einfaches Variieren der Pegelschwellen bzw. der Verzögerungszeiten eine fast beliebige Anpassung an ein Pegelschwankungen aufweisendes Taktsignal bzw. an die geforderten Reaktionszeiten vorgenommen werden.

Gemäß einer vorteilhaften Weiterbildung der Erfindung sind die Ausgangssignale der zweiten Kippstufe in Pegelschwankungen aufweisenden Taktsignalschritten verzögerbar. Hierbei kann das Ausgangssignal der zweiten Kippstufe um n*Taktimpulslängen - n ist abhängig von der Anzahl der von den Taktsignalen getakteten Verzögerungsglieder in der Verzögerungseinrichtung - verzögert werden. Mit Hilfe dieser Maßnahme wird eine Anpassung an die Änderungsgeschwindigkeit des Pegels aufeinander folgender Taktimpulse - z. B. das langsame Absinken des Pegels - der mittels Oberflächenwellenfilter zurückgewonnenen Taktsignale erreicht.

Eine vorteilhafte Möglichkeit der Realisierung des erfindungsgemäßen Verfahrens besteht in der im Patentanspruch 3 definierten Kombination von Merkmalen. Ein wesentlicher Vorteil dieser Schaltungsanordnung ist darin zu sehen, daß alle Systemkomponenten mittels digitaler Schaltkreistechnik realisierbar und somit für eine Integration in programmierbaren Logik-Array- oder kundenspezifischen Gate-Array-Schaltungstechniken geeignet sind.

Im Rahmen einer vorteilhaften Weiterbildung - Anspruch 5 - der Anordnung ist die erste Verzögerungseinrichtung mittels eines Schieberegisters und eines an bestimmte Schieberegisterausgänge angeschlossenen ODER-Verknüpfungsgliedes realisierbar. Mittels dieser Anordnung wird eine vom Wechsel der Binärinformation am Ausgang der zweiten Kippstufe abhängige, unterschiedliche Verzögerungszeit - unter-

2

EP 0 269 812 B1

schiedlich deshalb, um sicherzustellen, daß das aktuell am Ausgang des ODER-Verknüpfungsgliedes anliegende Taktsignal gesperrt wird, bevor auf das jeweils andere Taktsignal umgeschaltet wird - erzeugt.

Im folgenden wird ein Ausführungsbeispiel der Erfindung anhand eines Blockschaltbildes näher erläutert.

Das Blockschaltbild zeigt die zur Erläuterung der Erfindung notwendigen Systemkomponenten einer Taktumschalteeinrichtung für beispielsweise eine Zugriffseinrichtung, die dem Zugriff auf ein ringförmiges, mit hohen Datenübertragungsgeschwindigkeiten operierenden Netzes dient. Das ebenfalls nicht dargestellte Übertragungsmedium bzw. die Übertragungstechnik ist beispielsweise mittels Lichtwellenleiter bzw. Lichtwellenleitersender-Empfängertechnik realisierbar. Die Taktrückgewinnung erfolgt mittels eines auf Oberflächenwellenfiltern basierenden, nicht dargestellten Taktregeneratorbausteines, an dessen Ausgang Taktsignale t1 vorliegen. Bei im Datenbitstrom auftretenden Phasensprüngen oder fehlenden Datensignalen fallen die Pegel bzw. Amplituden der regenerierten Taktsignale t1 nicht sofort, sondern mit einer definierten Zeitkonstante ab. Die vom Taktregenerator kommende Taktsignale t1 werden jeweils einem invertierenden Eingang eines ersten Differenzverstärkers DV1 und einem invertierenden Eingang eines zweiten Differenzverstärkers DV2 zugeführt. Der zweite Eingang des ersten Differenzverstärkers DV1 ist mit einer Spannungsquelle, die eine auf das Taktsignal t1 abgestimmte obere Pegelschwelle u1 und der zweite Eingang des zweiten Differenzverstärkers DV2 ist mit einer zweiten Spannungsquelle, die eine wiederum auf das Taktsignal t1 abgestimmte untere Pegelschwelle u2 repräsentiert, verbunden. Beide Spannungsquellen u1, u2 sind mittels elektronischer Stabilisierungsschaltungen - z. B. Zenerdiode - und variierbarer Spannungsteilern realisierbar. Die Pegelschwellen u1, u2 sind auf die durch die Phasensprünge verursachten maximalen Pegelschwankungen und die absoluten Pegelverhältnisse der Taktsignale t1 abzustimmen. Der invertierende Ausgang des ersten Differenzverstärkers DV1 wird auf einen Setzeingang S und der Ausgang des zweiten Differenzverstärkers DV2 auf einen Rücksetzeingang R einer ersten Kippstufe K1 geführt. Der Ausgang dieser ersten Kippstufe K1 ist mit einem Rücksetzeingang R einer zweiten Kippstufe K2 verbunden. Der Ausgang dieser zweiten Kippstufe K2 wird zu einer vom Taktsignal t1 getakteten Verzögerungsstufe VZ1 geführt. Die Verzögerungseinrichtung VZ kann beispielsweise durch zwei weitere nicht dargestellte Kippstufen realisiert sein. Der Ausgang dieser Verzögerungseinrichtung VZ ist einerseits mit einem Eingang einer ersten Verzögerungseinrichtung VZ1 und andererseits über einen Inverter INV mit einem Eingang einer zweiten Verzögerungseinrichtung VZ2 verbunden. Die Verzögerungseinrichtung VZ2 wird beispielsweise mittels eines achtstufigen Schieberegisters SR2 gebildet. Eine auf die Änderungsgeschwindigkeit des Pegels des Taktsignals t1 abgestimmte Verzögerungszeit wird durch Auswahl eines der acht Ausgänge des Schieberegisters SR2 festgesetzt, wobei dieser ausgewählte Ausgang dem Ausgang A der zweiten Verzögerungseinrichtung VZ2 entspricht. Die erste Verzögerungseinrichtung VZ1 ist ebenfalls mittels eines achtstufigen Schieberegisters SR1 realisiert, jedoch sind vier der acht Ausgänge des Schieberegisters SR1 mit jeweils einem Eingang eines ersten ODER-Verknüpfungsgliedes OR1 verbunden und der Ausgang dieses ersten ODER-Verknüpfungsgliedes OR1 dem Ausgang A der ersten Verzögerungseinrichtung VZ1 zugeordnet ist. Mit dieser Anordnung wird erreicht, daß in Abhängigkeit von der Richtung des Übergangs des Binärinformation us am Eingang E der ersten Verzögerungseinrichtung VZ1 zwei unterschiedliche Verzögerungszeiten gebildet werden. Die Ausgänge der beiden Verzögerungseinrichtungen VZ1, VZ2 werden auf jeweils einen ersten Eingang eines ersten bzw. eines zweiten UND-Verknüpfungsgliedes UD1, UD2 geführt. Die Ausgänge der beiden UND-Verknüpfungsglieder UD1, UD2 sind mit den beiden Eingängen eines zweiten ODER-Verknüpfungsgliedes OR2 verbunden und der Ausgang dieses zweiten ODER-Verknüpfungsgliedes OR2 den Ausgang der Taktumschalteeinrichtung darstellt. Die die Pegelschwankungen aufweisenden Taktsignale t1 werden des weiteren über entsprechende Verbindungen an die Takteingänge der zweiten Kippstufe K2, der Verzögerungseinrichtung VZ und der ersten Verzögerungseinrichtung VZ1 sowie zum zweiten Eingang des ersten UND-Verknüpfungsgliedes UD1 geführt. Ein weiteres, annähernd digitales, internes Taktsignal t2 wird über entsprechende Leitungen an dem Takteingang des zweiten Verzögerungsgliedes VZ2 und an den zweiten Eingang des zweiten UND-Verknüpfungsgliedes UD2 geführt.

Weist das vom Taktgenerator kommende Taktsignal t1 ausreichende Pegelhöhe auf, so wird im mittels der beiden Differenzverstärker DV1, DV2 gebildeten Fensterdiskriminator FD beim Überschreiten der oberen Pegelschwelle u1 ein kurzer Setzimpuls si gebildet, mit dem die Kippstufe K1 gesetzt und bei Unterschreiten der unteren Pegelschwelle u2 ein kurzer Rücksetzimpuls ri gebildet wird, mittels dessen die Kippstufe K1 wieder zurückgesetzt wird. Diese beiden Schaltvorgänge sind notwendig, um die eventuell zu kurze Zeit, während der die obere Schwelle u1 überschritten wird, durch Einfügen einer Verzögerung bzw. Hysterese zu verlängern, bis die untere Schwelle u2 unterschritten ist. Mittels der durch das Setzen bzw. Rücksetzen in der ersten Kippstufe K1 erzeugten Impulse wird die zweite Kippstufe K2 solange zyklisch zurückgesetzt, solange die von der Taktregenerierungseinrichtung kommenden Taktsignale t1 ausrei-

3

chende Pegelhöhe aufweisen. Kann der Pegel bzw. die Amplitude des Taktsignals t1 die obere Pegelschwelle nicht mehr überschreiten, so wird kein Setzimpuls si und damit kein Impuls i am Ausgang der Kippstufe K1 gebildet und somit das Rücksetzen der zweiten Kippstufe K2 verhindert. Nach maximal einer Taktimpulslänge findet am Ausgang A der Kippstufe K1 ein Wechsel von beispielsweise dem logischen "0"-Zustand zum logischen "1"-Zustand statt. In der nachgestalteten Verzögerungseinrichtung VZ wird dieser Binärinformationswechsel um beispielsweise zwei Taktschritte verzögert an dessen Ausgang A geleitet. Dieser Informationswechsel stellt das eigentliche Umschaltesignal us dar, welches über den Inverter INV und über eine mit definierter Verzögerung versehene Verzögerungseinrichtung VZ2 zum zweiten UND-Verknüpfungsglied UD2 gelangt. Gleichzeitig wird dieses Umschaltesignal us zu der ersten Verzögerungseinrichtung VZ1 geführt und mit einer gegenüber der in der zweiten Verzögerungseinrichtung VZ2 definierten kleineren Verzögerungszeit verzögert an das erste UND-Verknüpfungsglied UD1 weitergeleitet. Der Binärinformationswechsel am Eingang des ersten UND-Verknüpfungsgliedes UD1 bewirkt ein sofortiges Sperren des Ausgangs des ersten UND-Verknüpfungsgliedes UD1, wodurch ein Weiterleiten der vom Taktregenerator ankommenden Taktsignale t1 unterbunden wird. Nach einer der Differenz der beiden Verzögerungszeiten entsprechenden Zeit erreicht das Umschaltesignal us den Eingang des zweiten UND-Verknüpfungsgliedes UD2 und bewirkt ein Freigeben des Ausgangs dieses zweiten Verknüpfungsgliedes, wodurch die intern erzeugten Taktsignale t2 an den Ausgang des UND-Verknüpfungsgliedes UD2 weitergeleitet werden. Durch das gleichzeitige Sperren der Ausgänge beider UND-Verknüpfungsglieder UD1, UD2 während der der Differenz der beiden Verzögerungszeiten entsprechenden Zeit wird sichergestellt, daß keine Überlagerung der Taktimpulse t1, t2 auftritt und somit keine Taktsignale t1, t2, die ein die getakteten Einrichtungen störendes Impuls-Pausenverhältnis aufweisen, über die Eingänge des zweiten ODER-Verknüpfungsgliedes OR2 an dessen Ausgang gelangen. Dadurch, daß jede der beiden Verzögerungseinrichtungen VZ1, VZ2 mit den jeweiligen abbzw. einzuschaltenden Taktsignalen verbunden ist, wird gewährleistet, daß die jeweiligen Taktsignale t1, t2 synchronisiert über die UND-Verknüpfungsglieder UD1, UD2 ein- bzw. abgeschaltet werden.

Überschreitet der Pegel bzw. die Amplitude der von der Taktrückgewinnungseinrichtung zugeführten Taktsignale t1 wieder die obere Pegelschwelle, so liegen wieder Impulse i am Ausgang der ersten Kippstufe K1 vor, was nach einer Verzögerung von zwei Taktschritten zu einem Binärinformationswechsel us am Ausgang der Verzögerungseinrichtung VZ führt. Dieser bewirkt einerseits, daß nach einer in der zweiten Verzögerungseinrichtung VZ2 definierten Verzögerungszeit mittels des zweiten UND-Verknüpfungsgliedes UD2 die intern erzeugten Taktsignale t2 nicht mehr an den Ausgang des zweiten ODER-Verknüpfungsgliedes OR2 und andererseits nach einer in der ersten Verzögerungseinrichtung VZ1 gegenüber der in der zweiten Verzögerungseinrichtung VZ2 größeren Verzögerungszeit mittels des ersten UND-Verknüpfungsglied UD1 die regenerierten Taktsignale t1 an den Ausgang A des zweiten ODER-Verknüpfungsgliedes OR2 gelangen.

Alle Systemkomponenten der Taktumschalteeinrichtung sind mittels integrierter ECL-Schaltkreise der schnellen 100 K-Technik von Fairchild realisierbar. Beispielhaft ist nachfolgend für die einzelnen Systemkomponenten jeweils eine Realisierungsmöglichkeit aufgelistet.

```
Differenzverstärker DV1, DV2              F 100 114
Kippstufen K1, K2                         F 100 131
Verzögerungseinrichtung VZ (Register)     F 100 151
Verzögerungseinrichtungen VZ1, VZ2
(achtstufiges Schieberegister)            F 100 141
UND-Verknüpfungsglied UD                   F 100 102
ODER-Verknüpfungsglied OR                  F 100 101
```

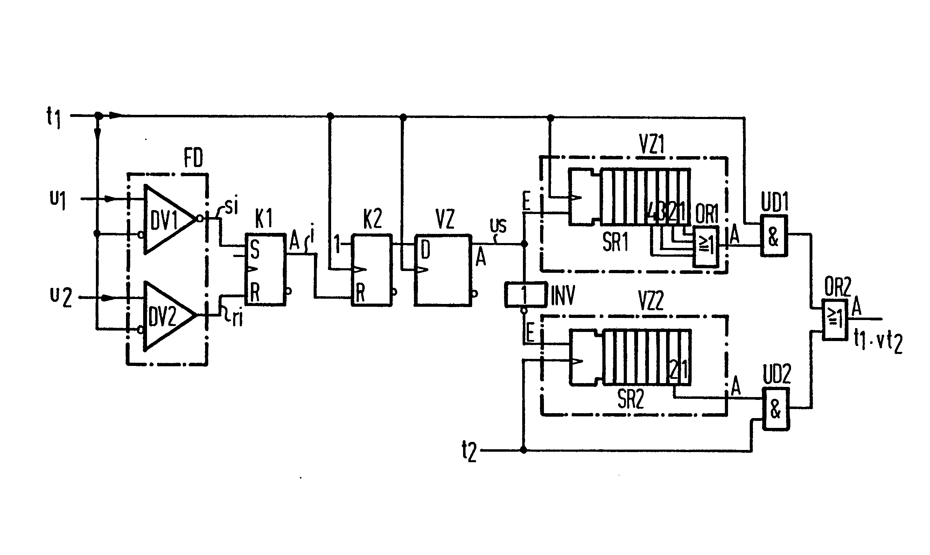

**Ansprüche**

1. Verfahren zur Versorgung einer Leitung mit Taktsignalen, die entweder aus Pegelschwankungen aufweisenden und über eine erste Leitung übertragenen Taktsignalen oder aus annähernd digitalen und über eine zweite Leitung übertragenen Taktimpulsen in Abhängigkeit vom Pegel der auf der ersten Leitung übertragenen Taktsignale gebildet sind,

**dadurch gekennzeichnet,**

daß jedes der Pegelschwankungen aufweisenden Taktsignale (t1) jeweils mit einer unteren und einer oberen Pegelschwelle (u1, u2) verglichen und bei Überschreiten der oberen Pegelschwelle (u1) ein Setzsignal (si) gebildet sowie bei Unterschreiten einer unteren Pegelschwelle (u2) ein Rücksetzsignal (ri) gebildet wird, die jeweils an einen Setz- bzw. Rücksetzeingang (S,R) einer ersten Kippstufe (K1) weitergeleitet werden und daß das in der ersten Kippstufe (K1) gebildete Ausgangssignal (i) an den Rücksetzeingang (R) einer mittels der Taktsignale (t1) getakteten zweiten Kippstufe (K2) geführt wird,

daß bei einem nach vorhergehendem Überschreiten der oberen Pegelschwelle (u1) erfolgenden Unterschreiten der unteren (u2) dieser Informationswechsel (us) vom Ausgang der zweiten Kippstufe (k2) mit vorgegebener erster Zeit verzögert an einen Eingang eines derart strukturierten Verknüpfungsgliedes (UD1) geführt wird, daß ein weiterleiten der am zweiten Eingang des ersten Verknüpfungsgliedes (UD1) anliegenden Taktsignale (t1) an den Ausgang des ersten Verknüpfungsgliedes (UD1) unterbunden wird und gleichzeitig die Ausgangssignale der zweiten Kippstufe (K2) um eine größer als die erste Zeit bemessene zweite Zeit verzögert und einem ersten Eingang eines derart strukturierten zweiten Verknüpfungsgliedes (UD2) zugeführt werden, daß die am zweiten Eingang des zweiten Verknüpfungsgliedes (UD2) anliegenden Taktimpulse (t2) an den Ausgang des zweiten Verknüpfungsgliedes (UD2) geleitet werden und daß bei einem nach vorhergehendem Überschreiten der oberen Pegelschwelle (u1) erfolgenden Unterschreiten derselben dieser Informationswechsel (us) mit der ersten Zeit verzögert zum derart strukturierten zweiten Verknüpfungsglied (UD2) geführt wird, daß der Ausgang des zweiten Verknüpfungsgliedes (UD2) gesperrt wird und daß gleichzeitig der Informationswechsel (us) um eine kleiner als die erste Zeit bemessene dritte Zeit verzögert und dem ersten derart strukturierten Verknüpfungsglied (UD1) zugeführt wird, daß die Taktsignale (t1) zum Ausgang des ersten Verknüpfungsgliedes (UD1) weitergeleitet werden

sowie daß die Tatktsignale (t1) bzw. die Taktimpulse (t2) an unterschiedliche Eingänge eines derart strukturierten Verknüpfungsgliedes (OR2) geleitet werden, daß an dessen Ausgang entweder die Taktsignale (t1) oder die Taktimpulse (t2) anstehen.

2. Verfahren nach Anspruch 1,

**dadurch gekennzeichnet,**

daß die Ausgangssignale der zweiten Kippstufe (K2) in Taktsignalschritten verzögerbar sind.

3. Anordnung zum Durchführen des Verfahrens nach Anspruch 1,

**dadurch gekennzeichnet,**

daß jeweils ein invertierender Eingang von zwei, einen Fensterdiskriminator bildenden Differenzverstärkern (DV1, DV2) mit der die Taktsignale (t1) führenden Leitung verbunden ist und an deren jeweils zweitem Eingang ein die obere Pegelschwelle (u1) bzw. die untere Pegelschwelle (u2) repräsentierendes Spannungspotential anliegt sowie daß die Ausgänge der Differenzverstärker (DV1, DV2) jeweils auf einen Rücksetzbzw. Setzeingang (R, S) einer ersten Kippstufe (K1) geführt sind, der Ausgang mit dem Rücksetzeingang (R) einer zweiten Kippstufe (K2) verbunden ist und der Ausgang der zweiten Kippstufe (K2) einerseits mit dem Eingang (E) einer ersten Verzögerungseinrichtung (VZ1) und andererseits mit dem Eingang (E) einer zweiten Verzögerungseinrichtung (VZ2) verbunden ist, daß die Ausgänge (A) der beiden Verzögerungseinrichtungen (VZ1, VZ2) an jeweils einen Eingang eines ersten und eines zweiten UND-Verknüpfungsgliedes (UD1, UD2) sowie dessen Ausgang auf jeweils einen Eingang eines ODER-Verknüpfungsgliedes (OR2) geführt ist, an dessen Ausgang (A) die Taktsignale (t1) oder die Taktimpulse (t2) anliegen, daß die die Taktsignale (t1) führende Leitung sowohl mit dem Takteingang der zweiten Kippstufe (K2) und der ersten Verzögerungseinrichtung (VZ1) als auch mit dem zweiten Eingang des ersten UND-Verknüpfungsliedes (UD1) verbunden ist und die die Taktimpulse (t2) führende Leitung mit dem Takteingang des zweiten Verzögerungsgliedes (VZ2) und dem zweiten Eingang des zweiten UND-Verknüpfungsgliedes (UD2) verbunden ist.

4. Anordnung zum Durchführen des Verfahrens nach Anspruch 3,

**dadurch gekennzeichnet,**

daß die zweite Verzögerungseinrichtung (VZ2) mittels eines Schieberegisters (SR2) realisiert ist und die Verzögerung durch Wahl eines der den Verzögerungseinrichtungsausgang darstellenden Schieberegisterausgang gebildet ist.

5. Anordnung zum Durchführen des Verfahrens nach Anspruch 3,

**dadurch gekennzeichnet,**

daß die erste Verzögerungseinrichtung (VZ1) mittels eines Schieberegisters (SR1) realisiert und mindestens drei die Verzögerungszeit bestimmende und auf die Verzögerungszeit der zweiten Verzögerungseinrichtung (VZ2) abgestimmte Schieberegisterausgänge auf ein ODER-Verknüpfungsglied (OR1) geführt sind und der Ausgang der ODER-Verknüpfungsgliedes (OR1) den Ausgang der ersten Verzögerungseinrichtung (VZ1) darstellt.

## Claims

1. Method for supplying a line with clock signals which are formed either from clock signals having level fluctuations and transmitted via a first line or from approximately digital clock pulses transmitted via a second line, in dependence on the level of the clock signals transmitted on the first line, characterized in that each of the clock signals (t1) having level fluctuations is compared in each case with a lower and an upper level threshold (u1, u2), and in the case of upward transgression of the upper level threshold (u1) a set signal (si) is formed and in the case of downward transgression of a lower level threshold (u2) a reset signal (ri) is formed, which are forwarded in each case to a set or reset input (S, R) respectively of a first trigger circuit (K1), and in that the output signal (i) formed in the first trigger circuit (K1) is conducted to the reset input (R) of a second trigger circuit (K2) clocked by the clock signals (t1), in that in the case of a downward transgression of the lower level threshold (u2) following a preceding upward transgression of the upper level threshold (u1), this information change (us) is conducted, delayed by predetermined first time, from the output of the second trigger circuit (K2) to an input of a logic element (UD1) which is constructed in such a way that a forwarding of the clock signals (t1) present at the second input of the first logic element (UD1) to the output of the first logic element (UD1) is suppressed and at the same time the output signals of the second trigger circuit (K2) are delayed by a second time dimensioned to be greater than the first time, and conducted to a first input of a second logic element (UD2) constructed in such a way that the clock pulses (t2) present at the second input of the second logic element (UD2) are forwarded to the output of the second logic element (UD2), and in that, in the case of a downward transgression of the upper level threshold (u1) following a preceding upward transgression of the same, this information change (us) is conducted, delayed by the first time, to the second logic element (UD2) constructed in such a way that the output of the second logic element (UD2) is inhibited and that simultaneously the information change (us) is delayed by a third time dimensioned to be shorter than the first time, and conducted to the first logic element (UD1) constructed in such a way that the clock signals (t1) are forwarded to the output of the first logic element (UD1), and in that the clock signals (t1) or the clock pulses (t2) are conducted to different inputs of a logic element (OR2) constructed in such a way that either the clock signals (t1) or the clock pulses (t2) are present at its output.

2. Method according to Claim 1, characterized in that the output signals of the second trigger circuit (K2) can be delayed in clock signal steps.

3. Arrangement for carrying out the method according to Claim 1, characterized in that in each case one inverting input of two differential amplifiers (DV1, DV2) forming a window discriminator is connected to the line carrying the clock signals (t1), and a voltage potential representing the upper level threshold (u1) or the lower level threshold (u2), respectively, is present in each case at the second input of said differential amplifiers, and in that the outputs of the differential amplifiers (DV1, DV2) are in each case conducted to a reset or set input (R, S) of a first trigger circuit (K1), the output is connected to the reset input (R) of a second trigger circuit (K2) and the output of the second trigger circuit (K2) is connected on the one hand to the input (E) of a first delay means (VZ1) and on the other hand to the input (E) of a second delay means (VZ2), in that the outputs (A) of the two delay means (VZ1, VZ2) are connected to in each case one input of a first and of a second AND logic element (UD1, UD2), and the output thereof is conducted to in each case one input of an OR logic element (OR2), at the output (A) of which the clock signals (t1) or the clock pulses (t2) are present, in that the line carrying the clock signals (t1) is connected both to the clock input of the second trigger circuit (K2) and of the first delay means (VZ1) and to the second input of the first AND logic element (UD1), and the line carrying the clock pulses (t2) is connected to the clock input of the second delay element (VZ2) and to the second input of the second AND logic element (UD2).

4. Arrangement for carrying out the method according to Claim 3, characterized in that the second delay means (VZ2) is realized by a shift register (SR2) and the delay is formed by selecting one of the shift register outputs representing the delay means output.

5. Arrangement for carrying out the method according to Claim 3, characterized in that the first delay means (VZ1) is realized by a shift register (SR1) and at least three shift register outputs determining the delay time and matched to the delay time of the second delay means (VZ2) are conducted to an OR logic element (OR1), and the output of the OR logic element (OR1) represents the output of the first delay means (VZ1).

## Revendications

1. Procédé pour alimenter une ligne avec des signaux de cadence, qui sont formés soit par des signaux de cadence, dont le niveau est variable et qui sont transmis par l'intermédiaire d'une première ligne, soit par des impulsions de cadence approximativement numériques, transmises par l'intermédiaire d'une seconde ligne, en fonction du niveau des signaux de cadence transmis dans la première ligne, caractérisé par le fait,

que chacun des signaux de cadence (t1), dont le niveau présente des variations, est comparé respectivement à des seuils de niveau inférieur et supérieur (u1, u2) et qu'un signal de positionnement (si) est formé lors du dépassement du seuil de niveau supérieur (u1) et un signal de remise à l'état initial (ri) est formé lors du dépassement par le bas d'un seuil de niveau inférieur (u2), ces signaux étant envoyés respectivement à des entrées de positionnement et de remise à l'état initial (S, R) d'un premier étage à bascule (K1) et que le signal de sortie (i) formé dans le premier étage à bascule (K1) est envoyé à l'entrée de remise à l'état initial (R) d'un second étage à bascule (K2) commandé de façon cadencé au moyen des signaux de cadence (r), que lors d'un dépassement par valeurs inférieures du seuil de niveau inférieur (u2), intervenant à la suite d'un dépassement précédent, par valeur supérieure, du seuil de niveau supérieur (u1), ce changement d'information (us) est envoyé, en étant retardé d'une première durée prédéterminée, par la sortie du second étage de basculement (K2), à une entrée d'un circuit combinatoire (UD1) structurée de telle sorte qu'une retransmission des signaux de cadence (t1) appliqués à la seconde entrée du premier circuit combinatoire (UD1) à la sortie de ce circuit est interrompue et que simultanément les signaux de sortie du second étage de bascule (K2) sont retardés d'une seconde durée dimensionnée à une valeur supérieure à la première durée, et sont envoyés à une première entrée d'un second circuit combinatoire (UD2) structuré de telle sorte que les impulsions de cadence (t2) appliquées à la seconde entrée du second circuit combinatoire (UD2) sont envoyées à la sortie de ce second circuit, et que lors d'un dépassement en valeurs inférieures du seuil de niveau supérieur (u1), intervenant après un dépassement précédent par valeur supérieure de ce seuil, ce changement d'information (us) est envoyé, en état retardé d'une première durée, au second circuit combinatoire (UD2) structuré de telle sorte que la sortie de ce circuit est bloquée et que, simultanément, le changement d'information (us) est envoyé, en un temps retardé d'une troisième durée dimensionnée de manière à être inférieure à la première durée, au premier circuit combinatoire (UD1) structuré de telle sorte que les signaux de cadence (t1) sont retransmis à la sortie de ce circuit, et

que les signaux de cadence (t1) ou les impulsions de cadence (t2) sont envoyés à des entrées différentes d'un circuit combinatoire (OR2), structuré de telle sorte que ni les signaux de cadence (t1) ni les impulsions de cadence (t2) n'apparaissent sur les sorties de ce circuit.

2. Procédé suivant la revendication 1, caractérisé par le fait que les signaux de sortie du second étage de bascule (K2) peuvent être retardés selon des pas du signal de cadence.

3. Dispositif pour la mise en oeuvre du procédé suivant la revendication 1, caractérisé par le fait que respectivement une entrée inverseuse de deux amplificateurs différentiels (DV1, DV2) qui forment un discriminateur à fenêtre, est reliée à la ligne véhiculant les signaux de cadence (t1) et qu'un potentiel de tension représentant le seuil de niveau supérieur (u1) ou le seuil de niveau inférieur (u2) est appliqué à la seconde entrée respective desdits amplificateurs et que les sorties des amplificateurs différentiels (DV1, DV2) sont envoyées respectivement à des entrées de remise à l'état initial et de positionnement (R, S) d'un premier étage à bascule bistable (K1), que la sortie est reliée à l'entrée de remise à l'état initial (R) d'un second étage à bascule (K2) et que la sortie du second étage à bascule (K2) est reliée d'une part à l'entrée (R) d'un premier dispositif de retardement (VZ1) et d'autre part à l'entrée (E) d'un second dispositif de retardement (VZ2), que les sorties (A) des deux dispositifs de retardement (VZ1, VZ2) sont raccordées respectivement à une entrée de premier et second circuits combinatoires ET (UD1, UD2), dont la sortie est raccordée à une entrée respective d'un circuit combinatoire OU (OR2), sur la sortie (A) duquel sont présents les signaux de cadence (t1) ou les impulsions de cadence (t2), que la ligne véhiculant les signaux de cadence (t) est reliée aussi bien à l'entrée de cadence du second étage à bascule (K2) et du premier dispositif de retardement (VZ1) ainsi qu'à la seconde entrée du premier circuit combinatoire ET (UD1) et que la ligne véhiculant les impulsions de cadence (t2) est reliée à l'entrée de cadence du second circuit de retardement (VZ2) et à la seconde entrée du second circuit combinatoire ET (UD2).

4. Dispositif pour la mise en oeuvre du procédé suivant la revendication 3, caractérisé par le fait que le second dispositif de retardement (VZ2) est réalisé au moyen d'un registre à décalage (SR2) et que le retard est obtenu grâce au choix d'une sortie du registre à décalage, qui représente la sortie du dispositif de retardement.

5. Dispositif pour la mise en oeuvre du procédé suivant la revendication 3, caractérisé par le fait que le premier dispositif de retardement (VZ1) est réalisé au moyen d'un registre à décalage (SR1) et qu'au moins trois sorties du registre à décalage, qui déterminent le retard et sort réglées sur le retard fourni par le second dispositif de retardement (VZ2) sort envoyées à un circuit combinatoire OU (OR1) et que la sortie du circuit combinatoire OU (OR1) représente la sortie du premier dispositif de retardement (VZ1).